# EUROPEAN PATENT APPLICATION

(11) **EP 2 787 552 A1**
(43) Date of publication of application: **08.10.2014**
(21) Application number: 11876402.6
(22) Date of filing: 28.11.2011
(51) Int. Cl.: H01L 51/54, H01L 51/56

(54) **POLYMERIC ELECTROLUMINESCENT DEVICE AND METHOD FOR PREPARING SAME**

(71) Applicant: Ocean's King Lighting Science & Technology Co., Ltd., Nanhai Rd., Nanshan Shenzhen, Guangdong 518054 (CN); Shenzhen Ocean's King Lighting Engineering Co. Ltd, Shenzhen, Guangdong (CN)
(72) Inventor: ZHOU, Mingjie, Shenzhen, Guangdong 518054 (CN); WANG, Ping, Shenzhen, Guangdong 518054 (CN); HUANG, Hui, Shenzhen, Guangdong 518054 (CN); LIANG, Lusheng, Shenzhen, Guangdong 518054 (CN)
(74) Representative: Brunetti, Fabrizio
(86) International application number: PCT/CN2011/083044
(87) International publication number: WO 2013/078590

(57) **Abstract**

The present invention relates to a polymeric electroluminescent device and a method for preparing the same. The device comprises a conductive anode substrate, a hole injecting layer, a hole transportation layer, an electron barrier layer, a light-emitting layer, an electron transportation layer, an electron injecting layer and a cathode laminated in succession, and the material for the electron barrier layer is one selected from lithium fluoride, lithium carbonate, lithium oxide and lithium chloride. By preparing lithium compound as an inorganic electron barrier layer, the polymeric electroluminescent device is made of cheap materials which are easily obtainable, and most importantly has a low work function of approximately 2.0eV, which can form a transition potential barrier of approximately 1.0eV with the light-emitting layer and can limit the recombination of electrons and holes as far as possible, thereby increasing the recombination possibility of excitons and in turn improving the light-emitting efficiency of the polymeric electroluminescent device.

## Description

### TECHNICAL FIELD

The present invention relates to a polymer electroluminescent device and a method for preparing the same.

### BACKGROUND ART

In 1987, C. W. Tang and VanSlyke of Eastman Kodak Company, U.S. reported that a high-brightness, high efficiency polymeric electroluminescent device (OLED) was prepared using ultra-thin film technique. In this OLED, the brightness at 10 V reached 1000 cd/m², the luminous efficiency was 1.51 lm/W, and the service life was more than 100 hours.

The principle of the light emission of OLED is based on that, under the effect of an applied electric field, electrons are injected from the cathode to the lowest unoccupied molecular orbital (LUMO) of an organic material, while holes are injected from the anode into the highest occupied molecular orbital (HOMO) of the organic material. Electrons and holes meet each other in the light-emitting layer, recombine with each other and form excitons which migrate under the effect of the electric field, transferring energy to the light-emitting material and exciting electrons to transit from ground state to excited state. The excited state energy is inactivated by radiation, which produces photons and releases energy.

In conventional electroluminescent devices, normally an organic material with a high LUMO energy level would be used as the electron blocking layer. The hole transport path is anode - hole transport layer - light-emitting layer, while the electron transport path is cathode - electron transport layer - light-emitting layer. When the holes and the electrons reach the light-emitting layer, they recombine with each other to form excitons to emit light. If the potential barrier between the LUMO energy levels of the light-emitting layer and the hole transport layer is low, the electrons may travel from the light-emitting layer to the hole transport layer, leading to ineffective recombination of the electrons and the holes, and low luminous efficiency. The traditional approach to block electrons is to deposit a layer of an organic material having high LUMO level (about 3.2 eV) between the light-emitting layer and the hole transport layer to block electrons and restrict electrons within the light-emitting layer. Usually, the electrons can be effectively blocked only when the potential barrier between the LUMOs of the electron blocking layer and the light-emitting layer is about 0.5 eV. However, the difference between the LUMO energy levels of the conventionally used materials and that of the light-emitting layer (the LUMO energy level of the light-emitting layer is about 3.5 eV) is often small, and the blocking effect is therefore not significant.

### SUMMARY OF THE INVENTION

Based on this, it is necessary to provide a polymer electroluminescent device which can effectively block electrons from entering the hole transport layer, and a method for preparing the same.

A polymer electroluminescent device may comprise an anode conductive substrate, a hole injection layer, a hole transport layer, an electron blocking layer, a light-emitting layer, an electron transport layer, an electron injection layer and a cathode, which may be sequentially stacked, the electron blocking layer being made from a material selected from lithium fluoride, lithium carbonate, lithium oxide and lithium chloride.

In a preferred embodiment, the anode conductive substrate is one selected from indium tin oxide glass, fluorine-doped tin oxide glass, aluminum-doped zinc oxide glass and indium-doped zinc oxide glass.

In a preferred embodiment, the hole injection layer is made form a material selected from molybdenum oxide, tungsten trioxide and vanadium pentoxide.

In a preferred embodiment, the hole transport layer is made from a material selected from 1,1-bis[4-[N,N'-di(p-tolyl)amino]phenyl]cyclohexane, N,N'-di(3-methylphenyl)-N,N'-diphenyl-4,4'-biphenyl diamine, 4,4',4"-tris(carbazol-9-yl) triphenyl amine, and N,N'-(1-naphthyl)-N,N'-diphenyl-4,4'-biphenyl diamine.

In a preferred embodiment, the electron transport layer is made from a material selected from 2-(4-biphenylyl)-5-(4-tert-butyl)phenyl-1,3,4-oxadiazole, 8-hydroxyquinoline aluminum, 4,7-diphenyl-1,10-phenanthroline, 1,2,4-triazole derivatives and N-arylbenzimidazole.

In a preferred embodiment, the light-emitting layer is made from an organic light-emitting material; or from a mixed material comprising an organic light-emitting material as a guest material dispersed in a host material in which the amount of the guest material is 1% - 20% by mass, and the host material is one or two of a hole transport material and an electron transport material, wherein the organic light-emitting material may be at least one selected from 4-(dicyanomethylene)-2-butyl-6-(1,1,7,7-tetramethyljulolidin-9-yl-vinyl)-4H-pyran, 8-hydroxyquinoline aluminum, bis(4,6-difluorophenylpyridine-N,C²) picolinatoiridium, bis(2-methyldibenzo[f,h]quinoxaline) (acetylacetonato) iridium and tris(2-phenylpyridine) iridium; the hole transport material may be one selected from 1,1-bis[4-[N,N'-di(p-tolyl)amino] phenyl]cyclohexane, N,N'-di(3-methylphenyl)-N,N'-diphenyl-4,4'-biphenyl diamine, 4,4',4"-tris(carbazol-9-yl) triphenyl amine, and N,N'-(1-naphthyl)-N,N'-diphenyl-4,4'-biphenyl diamine; and the electron transport material may be one selected from 2-(4-biphenylyl)-5-(4-tert-butyl)phenyl-1,3,4-oxadiazole, 8-hydroxyquinoline aluminum, 4,7-diphenyl-1,10-phenanthroline, 1,2,4-triazole derivatives and N-arylbenzimidazole.

In a preferred embodiment, the electron injection layer is made from a material selected from cesium carbonate, cesium azide and lithium fluoride.

In a preferred embodiment, the cathode is made from a material selected from silver, aluminum, platinum, and gold.

A method for preparing a polymer electroluminescent device may comprise the steps of:
providing an anode conductive substrate, and conducting a surface treatment thereon;
providing sequentially a hole injection layer, a hole transport layer, an electron blocking layer, a light-emitting layer, an electron transport layer, an electron injection layer and a cathode on the anode conductive substrate by vacuum deposition to give the polymer electroluminescent devices; wherein the electron blocking layer is made from a material selected from lithium fluoride, lithium carbonate, lithium oxide and lithium chloride.

In a preferred embodiment, the surface treatment on the anode conductive substrate comprises a step of treatment with oxygen plasma, wherein the treatment time is 2 to 15 minutes, and the power is 10 ∼ 50 W.

The inorganic electron blocking layer of the polymer electroluminescent device is prepared from a lithium compound, which is inexpensive and readily available. Most importantly, it has a work function as low as about 2.0 eV, so that a transition barrier of about 1.0 eV may be formed between the electron blocking layer and the light-emitting layer, which can restrict electrons in the light-emitting layer to the fullest extent possible to recombine with holes, so as to effectively block electrons from entering the hole transport layer, increase the probability of the recombination of the excitons, and further increase the luminous efficiency of the polymer electroluminescent device.

### BRIEF DESCRIPTION OF THE FIGURES

Figure 1 is schematic diagram of the structure of a polymer electroluminescent device according to an embodiment;
Figure 2 is a schematic flow chart for preparing a polymer electroluminescent device according to an embodiment;
Figure 3 shows the energy levels of a device comprising the inorganic electron blocking layer of Example 1;
Figure 4 is a plot showing the relationship between the brightness and the luminous efficiency of the polymer electroluminescent devices of Example 1 and of the Comparative Example.

### SPECIFIC EMBODIMENTS

In the following, the polymer electroluminescent device and the method for preparing the same will be described in further detail by mainly referring to the figures and specific embodiments.

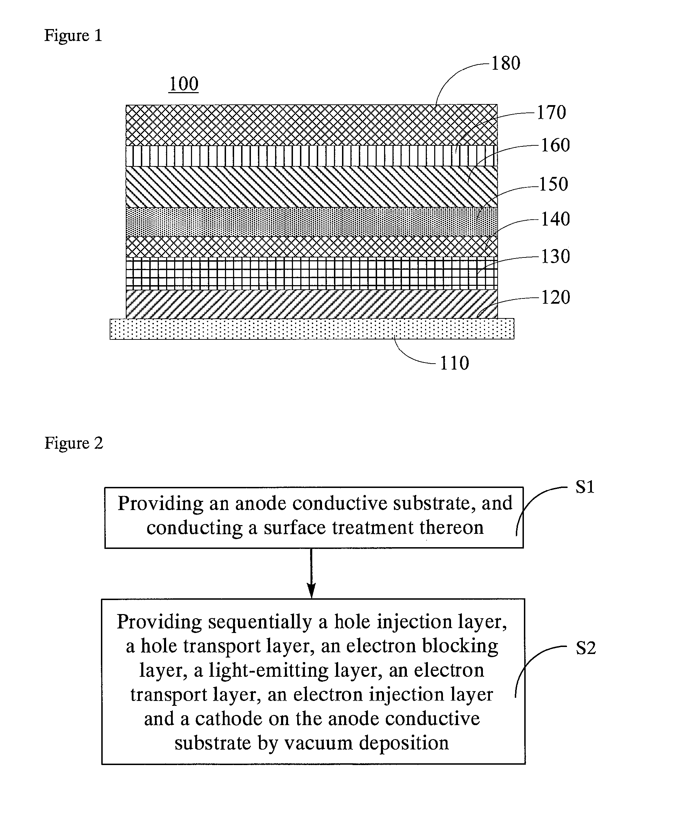

As shown in Figure 1, an polymer electroluminescent device 100 according to an embodiment comprises an anode conductive substrate 110, a hole injection layer 120, a hole transport layer 130, an electron blocking layer 140, a light-emitting layer 150, an electron transport layer 160, an electron injection layer 170 and a cathode 180, which are sequentially stacked.

The anode conductive substrate 110 is preferably one selected from indium tin oxide glass (ITO), fluorine-doped tin oxide glass (FTO), aluminum-doped zinc oxide glass (AZO) and indium-doped zinc oxide glass (IZO).

The hole injection layer 120 is preferably made from a material selected from molybdenum oxide (MoO₃), tungsten trioxide (WO₃) and vanadium pentoxide (V₂O₅), and preferably has a thickness of 20 ∼ 80 nm. More preferably, the hole injection layer 120 is made from MoO₃, and has a thickness of 40 nm.

The hole transport layer 130 is preferably made form a material selected from 1,1-bis[4-[N,N'-di(p-tolyl)amino]phenyl]cyclohexane (TAPC), N,N'-di(3-methylphenyl)-N,N'-diphenyl-4,4'-biphenyl diamine (TPD), 4,4',4"-tris(carbazol-9-yl) triphenyl amine (TCTA), and N,N'-(1-naphthyl)-N,N'-diphenyl-4,4'-biphenyl diamine(NPB), and preferably has a thickness of 20 - 60 nm. More preferably, the hole transport layer 130 is made form NPB, and has a thickness of 40 nm.

The electron blocking layer 140 is preferably made from a material selected from lithium fluoride (LiF), lithium carbonate (Li₂CO₃), lithium oxide (Li₂O), and lithium chloride (LiF), and preferably has a thickness of 0.7 - 5 nm.

The light-emitting layer 150 is made from an organic light-emitting material; or from a mixed material comprising an organic light-emitting material as a guest material dispersed in a host material in which the amount of the guest material is 1% - 20% by mass. The host material is one or two of a hole transport material and an electron transport material. The light-emitting layer 150 preferably has a thickness of 2-50 nm.

The organic light-emitting material may be at least one selected from 4-(dicyanomethylene)-2-butyl-6-(1,1,7,7-tetramethyljulolidin-9-yl-vinyl)-4H-pyran (DCJTB), 8-hydroxyquinoline aluminum (Alq₃), bis(4,6-difluorophenylpyridine-N,C²) picolinatoiridium (FIrpic), bis(2-methyl-dibenzo[f,h]quinoxaline) (acetylacetonato) iridium (Ir(MDQ)₂(acac)) and tris(2-phenylpyridine) iridium (Ir(ppy)₃). The hole transport material may be one selected from 1,1-bis[4-[N,N'-di(p-tolyl)amino] phenyl]cyclohexane (TAPC), N,N'-di(3-methylphenyl)-N,N'-diphenyl-4,4'-biphenyl diamine (TPD), 4,4',4"-tris(carbazol-9-yl) triphenyl amine (TCTA), and N,N'-(1-naphthyl)-N,N'-diphenyl-4,4'-biphenyl diamine (NPB); and the electron transport material may be one selected from 2-(4-biphenylyl)-5-(4-tert-butyl)phenyl-1,3,4-oxadiazole (PBD), 8-hydroxyquinoline aluminum (Alq₃), 4,7-diphenyl-1,10-phenanthroline (Bphen), 1,2,4-triazole derivatives (such as TAZ) and N-arylbenzimidazole (TPBI).

More preferably, the light-emitting layer 150 is made from Alq₃, and has a thickness of 30 nm.

The electron transport layer 160 is preferably made from a material selected from 2-(4-biphenylyl)-5-(4-tert-butyl)phenyl-1,3,4-oxadiazole, 8-hydroxyquinoline aluminum, 4,7-diphenyl-1,10-phenanthroline, 1,2,4-triazole derivatives and N-arylbenzimidazole, and preferably has a thickness of 40 - 80 nm. More preferably, the electron transport layer 160 is made from Bphen, and has a thickness of 60 nm.

The electron injection layer 170 is preferably made from a material selected from cesium carbonate (Cs₂CO₃), cesium azide (CsN₃) and lithium fluoride (LiF), and has a thickness of 0.5 - 10 nm. More preferably, the electron injection layer 170 is made from CsN₃, and has a thickness of 5 nm.

The cathode 180 is preferably made from a material selected from silver (Ag), aluminum (Al), platinum (Pt) and gold (Au), and preferably has a thickness of 80 - 250 nm. More preferably, the cathode 180 is made from Ag, and has a thickness of 100 nm.

The inorganic electron blocking layer of the polymer electroluminescent device is prepared from a lithium compound, which is inexpensive and readily available. Most importantly, it has a work function as low as about 2.0 eV, so that a transition barrier of about 1.0 eV may be formed between the electron blocking layer and the light-emitting layer, which can restrict electrons in the light-emitting layer to the fullest extent possible to recombine with holes, so as to increase the probability of the recombination of the excitons, and further increase the luminous efficiency and significantly increase the production efficiency of the polymer electroluminescent device.

As shown in Figure 2, a method for preparing a polymer electroluminescent device according to an embodiment comprises the following steps.

Step S1: providing an anode conductive substrate, and conducting a surface treatment thereon.

Preferably, the provided anode conductive substrate may be first washed sequentially with a detergent, deionized water, acetone, ethanol and isopropyl alcohol, sonicated in each case for a certain time, to remove dirt from the surface of the substrate. The washed anode conductive substrate is then subjected to a surface treatment, such as oxygen plasma treatment. The oxygen plasma treatment may be conducted for 2 to 15 minutes at a power of 10 ∼ 50 W. Preferably, the anode conductive substrate is subjected to oxygen plasma for 5 minutes at a power of 35 W.

Step S2: providing sequentially a hole injection layer, a hole transport layer, an electron blocking layer, a light-emitting layer, an electron transport layer, an electron injection layer and a cathode on the anode conductive substrate by vacuum deposition to give the polymer electroluminescent devices; wherein the electron blocking layer is made from a material selected from lithium fluoride, lithium carbonate, lithium oxide and lithium chloride.

The preparation process has advantages of simple mechanism, availability of raw materials, and high production efficiency, and therefore can be widely used.

In the following, specific examples are provided.

The instruments used in the following examples are as follows: high-vacuum coating equipment (Shenyang Scientific Instrument Development Center Co., Ltd., pressure: < 1 × 10⁻³ Pa), current - voltage tester (Keithly Instruments Inc., USA, Model: 2602), electroluminescent spectrometer (Photo Research, Inc., USA, Model: PR650), and screen luminance meter (Beijing Normal University, Model: ST-86LA).

### Example 1: ITO/MoO₃/NPB/LiF/Alq₃/Bphen/CsN₃/Ag

An ITO glass substrate is provided, cut into a suitable shape, washed sequentially with a detergent, deionized water, acetone, ethanol and isopropyl alcohol, sonicated in each case for 15 min, to remove dirt from the surface of the substrate. The washed anode conductive substrate is then subjected to oxygen plasma treatment for 5 minutes at a power of 35 W.

A hole injection layer having a thickness of 40 nm is prepared by vacuum deposition from MoO₃.

A hole transport layer having a thickness of 40 nm is prepared by vacuum deposition from NPB.

An electron blocking layer having a thickness of 1.5 nm is prepared by vacuum deposition from LiF.

A light-emitting layer having a thickness of 30 nm is prepared by vacuum deposition from Alq₃.

An electron transport layer having a thickness of 60 nm is prepared by vacuum deposition from Bphen.

An electron injection layer having a thickness of 5 nm is prepared by vacuum deposition from CsN₃.

A cathode having a thickness of 100 nm is prepared by vacuum deposition from Ag. The polymer electroluminescent device is thus obtained.

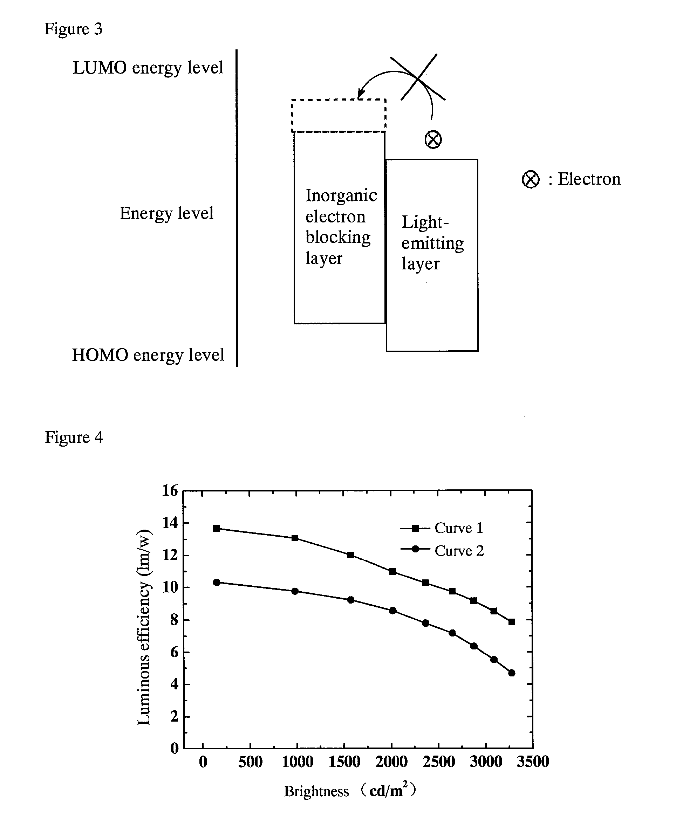

Figure 3 shows the energy levels of the device comprising the inorganic electron blocking layer of this example. The solid line represents the energy level of the electron blocking layer produced by using a traditional organic material, and the dotted line represents shows the increase of the LUMO energy level by preparing the electron blocking layer from LiF according to this example (the value of the energy level decreases from the bottom up). When the energy level is increased, the potential barrier for electrons to travel through the blocking layer increases considerably, which can restrict electrons in the light-emitting layer to recombine with holes and to increase the luminous efficiency.

### Example 2: IZO/WO₃/TPD/Li₂CO₃/DCJTB/PBD/Cs₂CO₃/Al

An IZO glass substrate is provided, cut into a suitable shape, washed sequentially with a detergent, deionized water, acetone, ethanol and isopropyl alcohol, sonicated in each case for 15 min, to remove dirt from the surface of the substrate. The washed anode conductive substrate is then subjected to oxygen plasma treatment for 2 minutes at a power of 50 W.

A hole injection layer having a thickness of 20 nm is prepared by vacuum deposition from WO₃.

A hole transport layer having a thickness of 50 nm is prepared by vacuum deposition from TPD.

An electron blocking layer having a thickness of 5 nm is prepared by vacuum deposition from Li₂CO₃.

A light-emitting layer having a thickness of 50 nm is prepared by vacuum deposition from DCJTB.

An electron transport layer having a thickness of 80 nm is prepared by vacuum deposition from PBD.

An electron injection layer having a thickness of 10 nm is prepared by vacuum deposition from Cs₂CO₃.

A cathode having a thickness of 250 nm is prepared by vacuum deposition from Al. The polymer electroluminescent device is thus obtained.

### Example 3: AZO/V₂O₅/TAPC/Li₂O/TPBI:Ir(ppy)₃/TAZ/CsN₃/Au

An AZO glass substrate is provided, cut into a suitable shape, washed sequentially with a detergent, deionized water, acetone, ethanol and isopropyl alcohol, sonicated in each case for 15 min, to remove dirt from the surface of the substrate. The washed anode conductive substrate is then subjected to oxygen plasma treatment for 15 minutes at a power of 10 W.

A hole injection layer having a thickness of 60 nm is prepared by vacuum deposition from V₂O₅.

A hole transport layer having a thickness of 60 nm is prepared by vacuum deposition from TAPC.

An electron blocking layer having a thickness of 2 nm is prepared by vacuum deposition from Li₂O.

A light-emitting layer having a thickness of 10 nm is prepared by vacuum deposition from TPBI : Ir(ppy)₃, wherein the amount of Ir(ppy)₃ in the light-emitting layer is 15% by mass.

An electron transport layer having a thickness of 40 nm is prepared by vacuum deposition from TAZ.

An electron injection layer having a thickness of 5 nm is prepared by vacuum deposition from CsN₃.

A cathode having a thickness of 80 nm is prepared by vacuum deposition from Au. The polymer electroluminescent device is thus obtained.

### Example 4: FTO/V₂O₅/TAPC/LiF/TPBI:Ir(MDQ)₂(acac)/TPBI/Cs₂CO₃/Au

An FTO glass substrate is provided, cut into a suitable shape, washed sequentially with a detergent, deionized water, acetone, ethanol and isopropyl alcohol, sonicated in each case for 15 min, to remove dirt from the surface of the substrate. The washed anode conductive substrate is then subjected to oxygen plasma treatment for 10 minutes at a power of 30 W.

A hole injection layer having a thickness of 40 nm is prepared by vacuum deposition from V₂O₅.

A hole transport layer having a thickness of 60 nm is prepared by vacuum deposition from TAPC.

An electron blocking layer having a thickness of 0.5 nm is prepared by vacuum deposition from LiF.

A light-emitting layer having a thickness of 2 nm is prepared by vacuum deposition from TPBI : Ir(MDQ)₂(acac), wherein the amount of Ir(MDQ)₂(acac) in the light-emitting layer is 1% by mass.

An electron transport layer having a thickness of 50 nm is prepared by vacuum deposition from TPBI.

An electron injection layer having a thickness of 0.5 nm is prepared by vacuum deposition from Cs₂CO₃.

A cathode having a thickness of 80 nm is prepared by vacuum deposition from Au. The polymer electroluminescent device is thus obtained.

### Example 5: ITO/MoO₃/TCTA/LiCl/TPBI:Firpic/Alq₃/CsN₃/Pt

An ITO glass substrate is provided, cut into a suitable shape, washed sequentially with a detergent, deionized water, acetone, ethanol and isopropyl alcohol, sonicated in each case for 15 min, to remove dirt from the surface of the substrate. The washed anode conductive substrate is then subjected to oxygen plasma treatment for 8 minutes at a power of 40 W.

A hole injection layer having a thickness of 80 nm is prepared by vacuum deposition from MoO₃.

A hole transport layer having a thickness of 30 nm is prepared by vacuum deposition from TCTA.

An electron blocking layer having a thickness of 4 nm is prepared by vacuum deposition from LiCl.

A light-emitting layer having a thickness of 25 nm is prepared by vacuum deposition from TPBI : Firpic, wherein the amount of Firpic in the light-emitting layer is 20% by mass.

An electron transport layer having a thickness of 35 nm is prepared by vacuum deposition from Alq₃.

An electron injection layer having a thickness of 7 nm is prepared by vacuum deposition from CsN₃.

A cathode having a thickness of 80 nm is prepared by vacuum deposition from Pt. The polymer electroluminescent device is thus obtained.

### Comparative Example: ITO/MoO₃/NPB/Alq₃/Bphen/CsN₃/Ag

An ITO glass substrate is provided, cut into a suitable shape, washed sequentially with a detergent, deionized water, acetone, ethanol and isopropyl alcohol, sonicated in each case for 15 min, to remove dirt from the surface of the substrate. The washed anode conductive substrate is then subjected to oxygen plasma treatment for 5 minutes at a power of 35 W.

A hole injection layer having a thickness of 40 nm is prepared by vacuum deposition from MoO₃.

A hole transport layer having a thickness of 40 nm is prepared by vacuum deposition from NPB.

An electron blocking layer having a thickness of 4 nm is prepared by vacuum deposition from LiCl.

A light-emitting layer having a thickness of 30 nm is prepared by vacuum deposition from Alq₃.

An electron transport layer having a thickness of 60 nm is prepared by vacuum deposition from Bphen.

An electron injection layer having a thickness of 5 nm is prepared by vacuum deposition from CsN₃.

A cathode having a thickness of 100 nm is prepared by vacuum deposition from Ag. The polymer electroluminescent device is thus obtained.

Figure 4 is a plot showing the relationship between the brightness and the luminous efficiency, wherein curve 1 represents the relationship between the brightness and the luminous efficiency of the device produced in Example 1; and curve 2 represents the relationship between the brightness and the luminous efficiency of the device produced in the Comparative Example. As can be seen from Figure 4, at different brightness, the luminous efficiency in Example 1 is higher than that in the Comparative Example. The maximum luminous efficiency in Example 1 is 13.7 1m/W, while that in the Comparative Example is only 10.3 lm/W, indicating that, when the inorganic electron blocking layer is used, electrons may be restricted in the electron-emitting layer to the fullest extent possible to recombine with holes, so as to increase the probability of the recombination of the excitons, and further increase the luminous efficiency and the light extraction efficiency.

The above Examples only describe several embodiments of the present invention, and the description is relatively specific and in detail. However, they cannot therefore be construed as limiting the scope of the present invention. It should be noted that those of ordinary skill in the art can make a number of modifications and improvements without departing from the concept the present invention. All these modifications and improvements fall within the scope sought protection in the present invention. Therefore, the scope sought protection in the present invention shall be subject to the appended Claims.

## Claims

1. A polymer electroluminescent device, comprising an anode conductive substrate, a hole injection layer, a hole transport layer, an electron blocking layer, a light-emitting layer, an electron transport layer, an electron injection layer and a cathode, which are sequentially stacked, **characterized in that** the electron blocking layer is made from a material selected from lithium fluoride, lithium carbonate, lithium oxide and lithium chloride.

2. The polymer according to Claim 1, **characterized in that** the anode conductive substrate is one selected from indium tin oxide glass, fluorine-doped tin oxide glass, aluminum-doped zinc oxide glass and indium-doped zinc oxide glass.

3. The polymer according to Claim 1, **characterized in that** the hole injection layer is made form a material selected from molybdenum oxide, tungsten trioxide and vanadium pentoxide.

4. The polymer according to Claim 1, **characterized in that** the hole transport layer is made from a material selected from 1,1-bis[4-[N,N'-di(p-tolyl)amino]phenyl] cyclohexane, N,N'-di(3-methylphenyl)-N,N'-diphenyl-4,4'-biphenyl diamine, 4,4',4"-tris(carbazol-9-yl) triphenyl amine, and N,N'-(1-naphthyl)-N,N'-diphenyl-4,4'-biphenyl diamine.

5. The polymer according to Claim 1, **characterized in that** the electron transport layer is made from a material selected from 2-(4-biphenylyl)-5-(4-tert-butyl)phenyl-1,3,4-oxadiazole, 8-hydroxyquinoline aluminum, 4,7-diphenyl-1,10-phenanthroline, 1,2,4-triazole derivatives and N-arylbenzimidazole.

6. The polymer according to Claim 1, **characterized in that** the light-emitting layer is made from an organic light-emitting material; or from a mixed material comprising an organic light-emitting material as a guest material dispersed in a host material in which the amount of the guest material is 1% - 20% by mass, and the host material is one or two of a hole transport material and an electron transport material,
wherein the organic light-emitting material is at least one selected from 4-(dicyanomethylene)-2-butyl-6-(1,1,7,7-tetramethyljulolidin-9-yl-vinyl)-4H-pyran, 8-hydroxyquinoline aluminum, bis(4,6-difluorophenylpyridine-N,C²) picolinatoiridium, bis(2-methyl-dibenzo[f,h]quinoxaline) (acetylacetonato) iridium and tris(2-phenylpyridine) iridium;
the hole transport material is one selected from 1,1-bis[4-[N,N'-di(p-tolyl)amino] phenyl]cyclohexane, N,N'-di(3-methylphenyl)-N,N'-diphenyl-4,4'-biphenyl diamine, 4,4',4"-tris(carbazol-9-yl) triphenyl amine, and N,N'-(1-naphthyl)-N,N'-diphenyl-4,4'-biphenyl diamine; and
the electron transport material is one selected from 2-(4-biphenylyl)-5-(4-tert-butyl) phenyl-1,3,4-oxadiazole, 8-hydroxyquinoline aluminum, 4,7-diphenyl-1,10-phenanthroline, 1,2,4-triazole derivatives and N-arylbenzimidazole.

7. The polymer according to Claim 1, **characterized in that** the electron injection layer is made from a material selected from cesium carbonate, cesium azide and lithium fluoride.

8. The polymer according to Claim 1, **characterized in that** the cathode is made from a material selected from silver, aluminum, platinum, and gold.

9. A method for preparing a polymer electroluminescent device, **characterized in that** the method comprises the steps of:
providing an anode conductive substrate, and conducting a surface treatment thereon;
providing sequentially a hole injection layer, a hole transport layer, an electron blocking layer, a light-emitting layer, an electron transport layer, an electron injection layer and a cathode on the anode conductive substrate by vacuum deposition to give the polymer electroluminescent devices; wherein the electron blocking layer is made from a material selected from lithium fluoride, lithium carbonate, lithium oxide and
lithium chloride.

10. The method for preparing a polymer electroluminescent device according to Claim 9, **characterized in that** the surface treatment on the anode conductive substrate comprises a step of treatment with oxygen plasma, wherein the treatment time is 2 to 15 minutes, and the power is 10 ∼ 50 W.
